# EUROPEAN PATENT APPLICATION

(11) **EP 2 420 582 A2**
(43) Date of publication of application: **22.02.2012**
(21) Application number: 10764618.4
(22) Date of filing: 12.04.2010
(51) Int. Cl.: C21D 1/09, C21D 1/42, C21D 9/46, C21D 10/00

(54) **SURFACE TREATMENT APPARATUS AND METHOD USING PLASMA**

(30) Priority: 14.04.2009 KR 20090032128; 05.06.2009 KR 20090049808
(71) Applicant: Dawonsys Co., Ltd., Ansan-si, Gyeonggi-do 425-836 (KR)
(72) Inventor: PARK, Sun Soon, Seoul 175-794 (KR); LIU, Hyo Yol, Ansan-si Gyeonggi-do 425-905 (KR)
(74) Representative: Richter Werdermann Gerbaulet Hofmann
(86) International application number: PCT/KR2010/002245
(87) International publication number: WO 2010/120079

(57) **Abstract**

The present invention relates to an apparatus and a method for plasma surface treatment, more particularly, to an apparatus and a method for treating a surface of a conductive object with ions from plasma. According to the present invention, an apparatus for plasma surface treatment which treats a surface of a treatment portion of a conductive object using ions from plasma comprising: connecting means electrically connected to the treatment portion for applying negative voltage pulses to the treatment portion; a pulse voltage generating unit electrically connected to the connecting means; and magnetic cores disposed at the boundary of the treatment portion for preventing electric current caused by the negative voltage pulses applied to the treatment portion from flowing across the boundary of the treatment portion is provided. The apparatus and method for plasma surface treatment according to the present invention can confine the treatment portion by using negative high voltage pulses and magnetic cores. Also, the apparatus and method can apply negative high voltage pulse to the treatment portion of an electrically grounded object such as a metal sheet coil and a metal wire coil.

## Description

### Technical Field

The present invention relates to an apparatus and a method for plasma surface treatment, more particularly, to an apparatus and a method for treating a surface of a conductive object with ions from plasma.

### Background Art

Thermal treatment of metal material such as a metal sheet or a metal wire without removing contaminants of the surface of the material causes surface contamination and defects. The contaminants such as rolling oils used in the process of cold rolling, dusts form a process are carbonized in the process of thermal treatment at the temperature of 1050 - 1100 °C, and become the cause of surface contamination and defects. Also, when a material being deposited or applied or joined on a surface of a conductive material such as a metal sheet or a metal wire, surface treatments of the conductive material such as cleaning or reforming of a surface of the metal sheet may enhance the adhesion.

Therefore, a method for treating a surface of a conductive material is needed. Some surface treatment methods such as using various chemicals or plasma are known.

Methods using chemicals remove organic materials by dipping the objects into organic solvents such as alkali, TCE. These methods are very complex processes needing alkali tank, electrolytic cleaning tank, warm water cleaning tank, and drying equipment. Also these methods have to maintain proper temperature and density to keep moderate reactivity. Therefore, these methods consume large amount of energy. Also, these methods use chemicals for treatments for a long time, and contaminants gathered on the surface of the chemicals degrade the quality of cleaning and fail to clean small gap. Also these methods are not eco-friendly.

Methods using plasma remove contaminants by impacting ions or radicals from plasma to the surface of a material. A method mainly using ions from plasma comprises the steps of positioning an object for surface treatment into a chamber filled with plasma of ions, applying high negative voltage to the object to accelerate the ions in a transition plasma sheath generated around surface of the object. And the accelerated ions impact on the surface of the object. This method reveals good effects in cleaning and reforming the surface of the object. Also this method is speedy. Also this method has a merit that it can remove inorganic contaminants including a metal oxide.

### Disclosure

### Technical Problem

Though the surface treatment method using ions from plasma has many merits, the method has some difficulties in applying to the following conditions. In case it is necessary to treat a portion of a surface of a conductive material, the method fails to treat the wanted portion of the surface, because high negative voltage applied to the object spread on all the surface of the object material.

Also, in case it is necessary to treat a surface of a conductive object continuously supplied and grounded such as metal sheet coil or a wound metal wire, the method fails to treat the surface of such object because high negative voltage can not be applied to the object and ions can not be accelerated.

The present invention is devised to solve the problems mentioned above. It is an object of the present invention to provide an apparatus and a method for treating a portion of a surface of a conductive material with ions from plasma. Another object of the present invention is to provide an apparatus and a method for treating a surface of conductive object continuously supplied such as a metal sheet or a metal wire.

### Technical Solution

According to the present invention, an apparatus for plasma surface treatment which treats a surface of a treatment portion of a conductive object using ions from plasma is provided. The apparatus comprises: connecting means electrically connected to the treatment portion for applying negative voltage pulses to the treatment portion; a pulse voltage generating unit electrically connected to the connecting means; and magnetic cores disposed at the boundary of the treatment portion for preventing electric current caused by the negative voltage pulses applied to the treatment portion from flowing across the boundary of the treatment portion.

Also, according to the present invention, a method for plasma surface treatment is provided. The method comprises the steps of: disposing magnetic cores at a boundary of a treatment portion of a conductive object for preventing electric current from flowing across the boundary of the treatment portion; supplying a process gas; generating plasma of ions surrounding the conductive object; and applying negative voltage pulses to the treatment portion of the conductive object to accelerate the ions from the plasma toward the conductive object to impact the conductive object with the ions.

Also, an apparatus for plasma surface treatment which treats a surface of a treatment portion of a conductive object using ions from plasma is provided. The apparatus comprises: at least a pair of pulse transformer cores disposed at the boundary of the treatment portion and configured to induce negative voltage pulses within the treatment portion; first winding wires wound around each of the pulse transformer cores; and a pulse voltage generating unit electrically connected to the first winding wires.

Also, according to the present invention, an apparatus for plasma surface treatment which treats a surface of a treatment portion of a conductive object using ions from plasma is provided. The apparatus comprises: a pulse transformer core disposed at the boundary of the treatment portion for inducing negative voltage pulses in the treatment portion; a first winding wire wound around the pulse transformer core; a pulse voltage generating unit electrically connected to the first winding wire; and a magnetic core disposed at the boundary of the treatment portion for preventing electric current caused by the negative voltage pulses in the treatment portion from flowing across the boundary of the treatment portion.

Also, according to the present invention, a method for plasma surface treatment is provided. The method comprises the steps of: disposing at least a pair of pulse transformer cores configured to induce negative voltage pulses within a treatment portion of a conductive object at the boundary of the treatment portion; supplying a process gas; generating plasma of ions surrounding the conductive object; and accelerating the ions from the plasma toward the conductive object to impact the conductive object with the ions by applying negative voltage pulses to the pair of pulse transformer cores.

Also, according to the present invention, a method for plasma surface treatment is provided. The method comprises the steps of: disposing a pulse transformer core configured to induce negative voltage pulses in a treatment portion of a conductive object at the boundary of the treatment portion; disposing a magnetic core at the boundary of the treatment portion of the conductive object for preventing electric current from flowing across the boundary of the treatment portion; supplying a process gas; generating plasma of ions surrounding the conductive object; and accelerating the ions from the plasma toward the conductive object to impact the conductive object with the ions by applying negative voltage pulses to the pair of pulse transformer cores.

### Advantageous Effects

The apparatus and method for plasma surface treatment according to the present invention have advantageous effects as below.

First, the apparatus and method for plasma surface treatment according to the present invention can confine the treatment portion by using negative high voltage pulses and magnetic cores. Also, the apparatus and method can apply negative high voltage pulse to the treatment portion of an electrically grounded object such as a metal sheet coil and a metal wire coil.

Second, the apparatus and method for plasma surface treatment according to the present invention use plasma ions accelerated by negative high voltage pulses. Thus, surface treatment speed of the present invention is faster than the conventional methods. Therefore, the apparatus and method can be applied to object supplied continuously at high speed.

Third, the apparatus and method for plasma surface treatment according to the present invention use plasma ions. Thus, the apparatus and method can be used reliably without restrictions on size or shape of objects.

Fourth, the apparatus and method for plasma surface treatment according to the present invention do not use any chemicals. Therefore, there are no issues of waste chemicals treatment and pollution.

### Brief Description of the Drawings

FIG. 1 is a schematic diagram of a first embodiment of an apparatus for plasma surface treatment according to the present invention;

FIG. 2 illustrates the shape of high negative voltage pulses in the present invention;

FIG. 3 is a perspective view of a magnetic cores installed in the apparatus for plasma surface treatment illustrated in FIG. 1;

FIG. 4 is an electrical equivalent circuit of the portion illustrated in FIG. 3;

FIG. 5 is a schematic diagram of a second embodiment of an apparatus for plasma surface treatment according to the present invention;

FIG. 6 shows a placement of a pulse transformer installed in the apparatus for plasma surface treatment illustrated in FIG. 5;

FIG. 7 is an electric potential distribution diagram induced on a surface of a metal sheet by the pulse transformer illustrated in FIG. 6;

FIG. 8 shows a placement of a pulse transformer installed in a third embodiment of an apparatus for plasma surface treatment according to the present invention;

FIG. 9 is a schematic diagram of a forth embodiment of an apparatus for plasma surface treatment according to the present invention;

FIG. 10 shows a placement of a pulse transformer and magnetic cores of the apparatus for plasma surface treatment illustrated in FIG. 9;

FIG. 11 an electrical equivalent circuit of the portion illustrated in FIG. 10;

<Brief descriptions of reference numerals>

110, 210, 310 : vacuum chamber 120, 220, 320: vacuum pump

130, 230, 330 : gas providing unit 140, 240, 340: plasma generating unit

150, 250, 350 : pulse voltage generating unit 160: electric roller

170, 370 : magnetic core 180, 280, 380 : un-winder

190, 290, 390 : winder 260, 270: pulse transformer

### Best Modes for carrying out the invention

Hereinafter, with reference to the figures attached, embodiments according to the present invention will be described.

[The first embodiment]

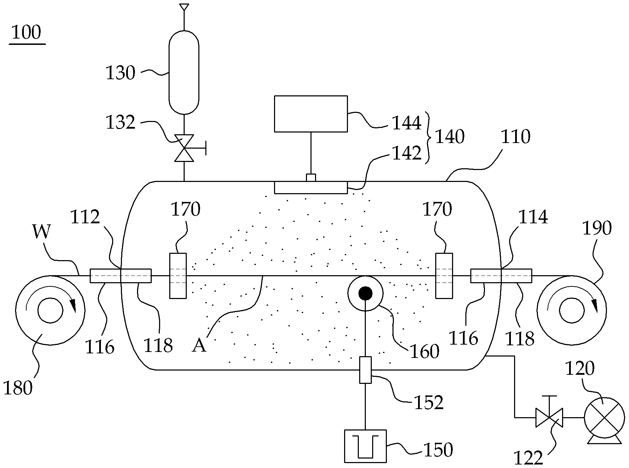

FIG. 1 is a schematic diagram of a first embodiment of an apparatus for plasma surface treatment according to the present invention. The first embodiment is an apparatus for plasma surface treatment of a metal sheet coil supplied continuously. With reference to FIG. 1, the present embodiment comprises a vacuum chamber 110, a vacuum pump 120, a gas supplying unit 130, a plasma generating unit 140, a pulse voltage generating unit 150, an electric roller 160, and magnetic cores 170.

The vacuum chamber 110, for providing a vacuum atmosphere for a treatment portion A of a metal sheet coil W, includes an inlet 112 formed at the upstream of the vacuum chamber 110 and an outlet 114 formed at the downstream of the vacuum chamber 110. The metal sheet coil W is provided through the inlet 112 of the chamber into the inside of the vacuum chamber 110, and goes throughout the outlet 114 after plasma surface treatment. Vacuum maintenance means 116 are installed respectively at the inlet 112 and at the outlet 114. The vacuum maintenance means 116 maintain vacuum by preventing outside air from flowing into the vacuum chamber 110, when the metal sheet W is provided into the inside of the vacuum chamber 110 and discharged from the vacuum chamber 110. The present embodiment also includes an un-winder 180 for providing the metal sheet coil W continuously into the inside of the vacuum chamber 110 and a winder for winding metal sheet W discharged from the vacuum chamber continuously after plasma surface treatment.

The vacuum pump 120 discharges gases out of the vacuum chamber 110 and produces a vacuum inside the vacuum chamber 110. A vacuum valve 122 is installed between the vacuum pump 120 and the vacuum chamber 110.

The gas providing unit 130 provides a gas for generating plasma into the vacuum chamber 110. The gas providing unit 130 can include a gas providing valve, and the gas providing valve is installed between the gas providing unit 130 and the vacuum chamber 110. The gas provided by the gas providing unit may be nitrogen (N₂), hydrogen (H₂), oxygen (O₂), neon (Ne), argon (Ar), and/or may be any combinations of the gases enumerated.

The plasma generating unit 140 generates plasma atmosphere inside the vacuum chamber 110. The plasma generating unit 140 includes a plasma electrode 142 for generating plasma and a plasma electric source 144 for providing electric power to the plasma electrode 142. The plasma electric source 144 provides electric power to the plasma electrode 142 through feed through. When electric power being applied to the plasma electrode 142, molecules of a gas around the plasma electrode 142 are ionized, and a plasma state in which positive ions and negative electrons are mixed is developed inside the vacuum chamber 110.

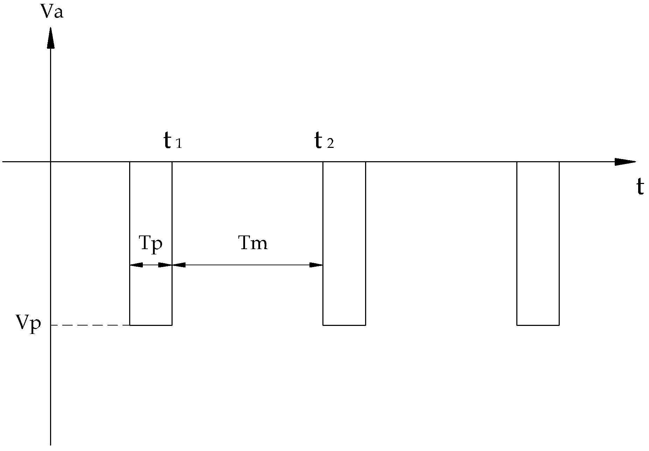

The pulse voltage generating unit 150 generates negative voltage pulses which are applied to the treatment portion A of the metal sheet coil W. When the negative voltage pulses being applied to the treatment portion A of the metal sheet coil W, a transition plasma sheath is formed around the surface of the treatment portion A of the metal sheet coil W, and ions inside the transition plasma sheath are accelerated toward the surface of the treatment portion A of the metal sheet coil W and impact on the surface of the treatment portion A of the metal sheet coil W. Therefore, plasma surface treatment of the metal sheet is accomplished. With reference to FIG. 2, the high voltage pulse generated by the pulse voltage generating unit 150 has pulse duration Tp ranging from 50 nS (nano-second) to 500 mS (milli-second) and pulse magnitude Vp ranging from - 100 kV to -10 V. And it is desirable that the negative high voltage pulse has the ratio of Tp to Tm ranging from 1 : 5 to 1 : 50,000, wherein Tp stands for pulse duration and Tm stands for time duration between pulse stop time t1 and next pulse start time t2.

The electric roller 160 is installed rotatably inside the vacuum chamber 110. The electric roller 160 is in contact with the lower surface of the treatment portion A of the metal sheet coil W. And the electric roller 160, being rotated on the surface of metal sheet W, supports the metal sheet W and simultaneously guides the metal sheet W. Also, the electric roller 160 applies negative high voltage pulses generated from the pulse voltage generating unit 150 to the treatment portion A of the metal sheet coil W. The pulse voltage generating unit 150 provides electric roller placed inside vacuum chamber 110 with electric power through feed through 152. Since the electric roller 160 is installed rotatably, the friction between the electric roller 160 and the metal sheet W can be reduced. Also the enhanced contact between the electric roller 160 and the metal sheet W secures the electric contact between the electric roller 160 and the metal sheet coil W.

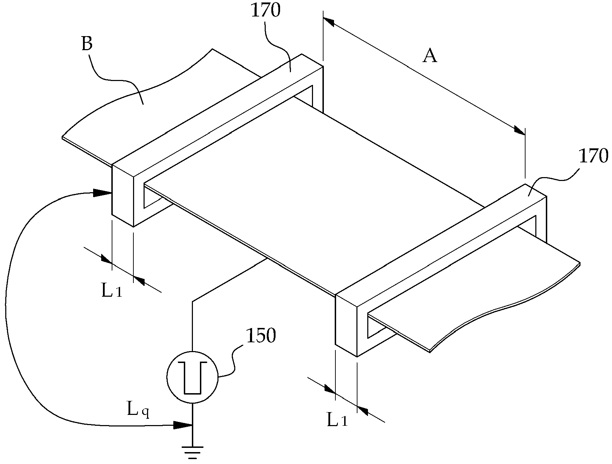

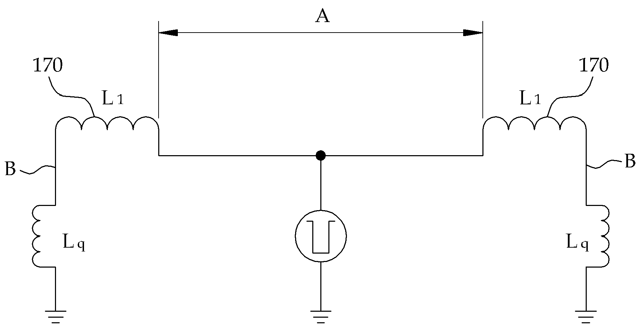

One magnetic core 170 is installed at the upstream side of the treatment portion A of the metal sheet coil W and the other magnetic core 170 is installed at the downstream side of the treatment portion A of the metal sheet coil W. The magnetic cores 170 prevent electric current, which is caused by the application of the negative voltage pulse to the treatment portion A of the metal sheet coil W, from flowing across the boundary of the treatment portion A of metal sheet coil W. FIG. 3 is a perspective view of magnetic cores 170 installed in the apparatus 100 for plasma surface treatment illustrated in FIG. 1 and FIG. 4 is an electrical equivalent circuit of the portion illustrated in FIG. 3. With reference to FIG. 3, magnetic cores 170 are in the form of closed loop encompassing a portion of the metal sheet W inside the vacuum chamber 110. The metal sheet supplied continuously passes through the opening of the magnetic core 170 which is in the form of loop. The surface of the opening of the magnetic core 170 is spaced predetermined distance apart from the metal sheet W.

With reference to FIG. 3 and FIG. 4, hereinafter it is described that how the magnetic cores 170 prevent the electric current generated by the application of the negative voltage pulses from flowing across the boundary of the treatment portion A of the metal sheet W. The magnetic cores 170 made of a material having high relative permeability have high inductance L1. The outside portion B of the metal sheet W from the boundary of the treatment portion A to the grounded portion of the metal sheet has inductance Lq. Since the metal sheet W is wound on both the un-winder 180 and the winder 190, the metal sheet W is connected with the un-winder 180 and the winder 190 physically and electrically. Since the un-winder 180 and the winder 190 are grounded, the metal sheet W is grounded.

The voltage pulse applied to the treatment portion A equals the sum of the voltage drop at magnetic core 170 and the voltage drop at the outside portion B of the metal sheet W. Though there is a voltage drop caused by the resistance of the metal sheet W, since high frequency pulses are applied to the treatment portion A, the reactance generated by the inductance of the magnetic cores 170 and outside portion B is much higher than the resistance of the metal sheet W. Therefore, the voltage drop caused by the resistance of the metal sheet W is negligible, and the equivalent circuit shown in FIG 4 can be configured only with the inductance. The voltage drop at magnetic cores 170 is proportional to L1 and the voltage drop of the treatment portion A is proportional to Lq. If the inductance L1 is much higher than the inductance Lq, the voltage drop at the magnetic cores 170 is dominant. It is necessary that the inductance L1 of magnetic cores 170 is much higher than that of the outside portion B in order to apply the negative high voltage pulses to the treatment portion A without loss. In order to increase the inductance of the magnetic cores 170, it is desirable to use material having higher relative permeability.

With reference to the figures, the functioning of the apparatus 100 for plasma surface treatment will be described below.

First, vacuum state is produced inside the vacuum chamber 110 by the working of the vacuum pump 120, and then a gas for generating plasma is supplied into the vacuum chamber 110. The gas can be selected from the group of nitrogen (N₂), hydrogen (H₂), oxygen (O₂), neon (Ne), argon (Ar), and/or may be any combinations of the gases enumerated according to the purpose of surface treatment. If the condition of the vacuum chamber 110 becomes a proper condition for plasma generation, the plasma generation unit 140 is operated to produce a plasma state inside the vacuum chamber 110. The method for producing plasma is well known to the person skilled in the technical fields of plasma.

Next, the metal sheet coil W wound at the un-winder is supplied into the vacuum chamber 110 through the inlet 112. Since the lip seal 116 is mounted at the inlet 112, it is possible to provide the metal sheet W into the vacuum chamber 110 maintaining vacuum state. The metal sheet W passes through the magnetic core 170 installed between the inlet 112 and the electric roller 160. In sequence the metal sheet W passes through the magnetic core 170 installed between the electric roller 160 and the outlet 114, and the metal sheet W is discharged outside the vacuum chamber 110. Since another lip seal 116 is mounted at the outlet 114, it is possible to discharge the metal sheet W outside the vacuum chamber 110 maintaining vacuum state. In the process of providing and discharging the metal sheet W, the electric roller 160 keeps contacting with the lower surface of the metal sheet W.

When the treatment portion A of the metal sheet W passes through the upstream side magnetic core 170, negative high voltage pulses are generated from the pulse voltage generating unit 150. The negative high voltage pulses are applied to the treatment portion A of the metal sheet W through the electric roller 160 connected with the pulse voltage generating unit 150. The electric current caused by the negative high voltage pulses is blocked by the magnetic cores 170 mounted both at the upstream boundary of the treatment portion A and at the downstream boundary of the treatment portion A. Therefore, the surface treatment portion is confined to the portion A located between the upstream magnetic core 170 and the downstream magnetic core 170. If the treatment portion is not confined by the magnetic cores 170, it is impossible to apply negative voltage on the metal sheet W inside vacuum chamber. The electric current caused by the negative high voltage pulses will flow through the metal sheet W to the ground without the confinement of the magnetic cores 170.

Next, a plasma sheath is generated around the treatment portion A by the negative high voltage pulses, and positive ions in the plasma sheath are accelerated toward the treatment portion A, and impact on the surface of the treatment portion A. Contaminants on the surface of the treatment portion are removed by the collision of the ions. The metal sheet W of which surface was treated discharged through the outlet 114 of the vacuum chamber 110 and is wound by the winder 190 as described above. By these processes described above it is possible to accomplish the surface treatment of a conductive metal object continuously.

[The second embodiment]

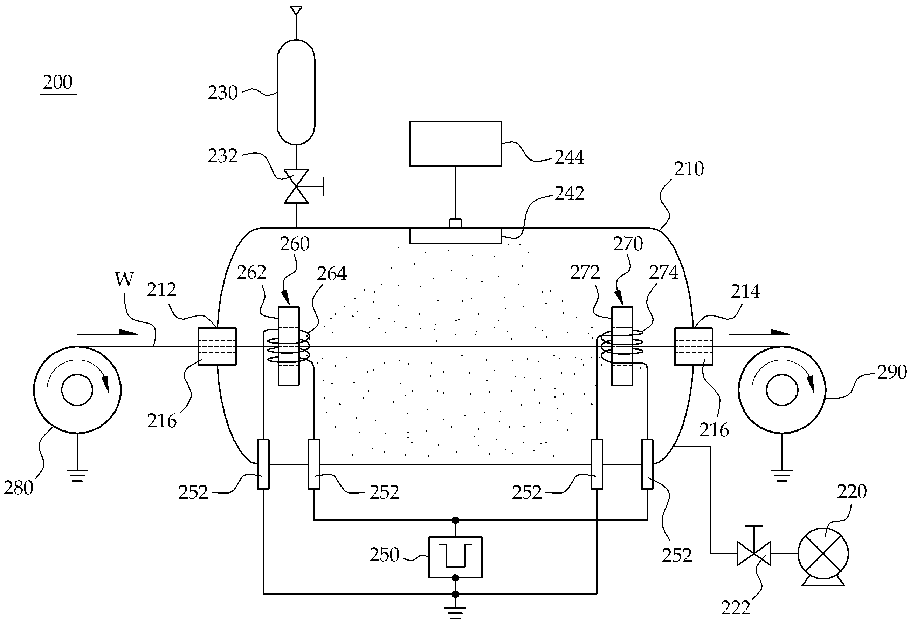

FIG. 5 is a schematic diagram of a second embodiment of an apparatus for plasma surface treatment according to the present invention. The apparatus for plasma surface treatment of this embodiment is an apparatus for a metal sheet coil provided continuously. Referring to FIG. 5, the apparatus for plasma surface treatment of this embodiment comprises a vacuum chamber 210, a vacuum pump 220, a gas providing unit 230, a plasma generating unit 240, a pulse voltage generating unit 250, pulse transformers 260, 270. In this embodiment, the apparatus for plasma surface treatment uses the pulse transformers 260, 270 instead of the electric roller 160 and the magnetic cores 170 of the first embodiment. The pulse transformers 260, 270 induce negative voltage pulse and prevent the electric current from flowing across the treatment portion A of the metal sheet W.

The pulse transformers 260, 270 are disposed at the upstream and downstream of treatment portion A of the metal sheet W respectively. The pulse transformers 260, 270 include transformer cores 262, 272 and first winding wires 264, 274 and the metal sheet W takes a role of a second winding wire of the pulse transformers 260, 270. The pulse transformers 260, 270 can induce negative voltage pulse to the metal sheet W, because the first winding wires 264, 274 are connected with pulse voltage generating unit 250 and the metal sheet W acts as a second winding wire of the pulse transformers 260, 270.

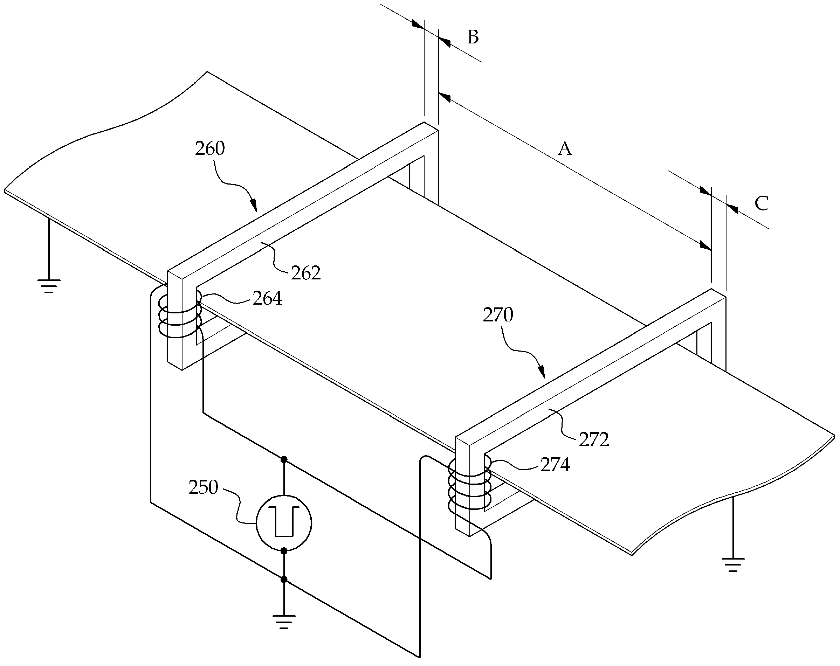

FIG. 6 shows a placement of a pulse transformer installed in the apparatus for plasma surface treatment illustrated in FIG. 5. Referring to FIG. 6, the transformer cores 262, 272 are closed-loops encompassing the metal sheet W at a predetermined distance. The metal sheet W passes through the openings of closed-loops. The material, magnetic flux density, and shape parameters etc., of the transformer cores 262, 272 are determined by considering magnitude of voltage pulses applied to the first winding wires 264, 274, and magnitude and frequency of the voltage pulse induced to the treatment portion A.

The first winding wires 264, 274 are made of metal such as copper. The first winding wires 264, 274 are electrically connected with the pulse voltage generating unit 250, so that voltage pulses generated by the pulse voltage generating unit 250 is applied to the pulse transformers 260, 270. The pulse voltage generating unit 250 supplies electric power through feed through 252 to the pulse transformers 260, 270 in the vacuum chamber 210. When the voltage pulses are applied to the first winding wires 264, 274, a magnetic field is induced and magnetic lines of force of the magnetic field pass through the transformer cores 262, 272. The magnetic lines of force passing through the transformer cores 262, 272 induce a voltage pulse to the metal sheet W acting as the second winding wire by Faraday's law of induction. In brief, the voltage pulses generated by the pulse voltage generating unit 250 induce the voltage pulses to the treatment portion A of a metal sheet W through the pulse transformers 260, 270.

The pulse transformers 260, 270 are disposed at the upstream and downstream of the treatment portion A of the metal sheet W respectively. Each of the first winding wires 264, 274 of the pulse transformers 260, 270 is wound in opposite direction. Each of the first winding wires 264, 274 wound in opposite direction induces negative voltage pulses to the treatment portion A of the wound metal sheet W. Each of the voltages induced by pulse transformer 260, 270 has the same magnitude in opposite direction. As a result, the resultant voltage induced to the metal sheet W by the pulse transformers 260, 270 is applied only within the treatment portion A and offset outside the treatment portion A.

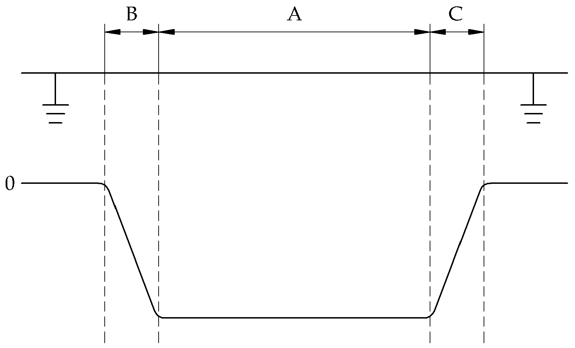

FIG. 7 is an electric potential distribution diagram induced on a surface of a metal sheet by the pulse transformer illustrated in FIG. 6. Referring to FIG. 7, it will be described in more detail how the voltages induced to the metal sheet W outside the treatment portion A mutually offset.

When a negative voltage pulse is applied to the first winding wire 264 of the pulse transformer 260 at the upstream of the treatment portion A, a magnetic field is induced by the first winding wire 264 and a voltage pulse is induced to metal sheet W acting as the second winding wire, and there is a voltage drop at the portion B of the metal sheet W where pulse transformer 260 is disposed. The frequency of the negative voltage pulse is so high that a voltage drop at the treatment portion A of metal sheet W due to the resistance of the metal sheet W can be ignored in compare with the voltage drop at the portion B of the metal sheet W. When the negative voltage pulse is applied simultaneously to the first winding wire 274 of pulse transformer 270 at the downstream of the treatment portion A, a voltage is induced to metal sheet W, and the first winding wires 274 of the pulse transformers 270 are wound in opposite direction of the first winding wires 264 of the pulse transformers 260. Thus, there is a voltage rise at the portion C of the metal sheet W where the pulse transformer 270 is disposed. The magnitude of the voltage rise at the portion C is similar to the magnitude of the voltage drop at the portion B. As a result, voltage induced to the metal sheet W is mutually offset outside the treatment portion A.

With reference to the figures, the functioning of the apparatus 200 for plasma surface treatment will be described below.

First, vacuum state is produced inside the vacuum chamber 210 by the working of the vacuum pump 220, and then a gas for generating plasma is supplied into the vacuum chamber 210. The gas can be selected from the group of nitrogen (N₂), hydrogen (H₂), oxygen (O₂), neon (Ne), argon (Ar), and/or may be any combinations of the gases enumerated according to the purpose of surface treatment. When the condition of the vacuum chamber 210 becomes a proper condition for plasma generation, the plasma generation unit 240 is operated to produce a plasma state inside the vacuum chamber 210. The method for producing plasma is well known to the person skilled in the technical fields of plasma.

Next, the metal sheet W wound at the un-winder in roll type is supplied into the vacuum chamber 210 through the inlet 212. Since a lip seal 216 for vacuum is mounted at the inlet 212, it is possible to provide the metal sheet W into the vacuum chamber 210 maintaining vacuum state. The metal sheet W passes through the pulse transformer 260 installed near the inlet 212. In sequence the metal sheet W passes through the pulse transformer 270 installed near the outlet 214, and the metal sheet W is discharged outside the vacuum chamber 210. Since another lip seal 216 is mounted at the outlet 214, it is possible to discharge the metal sheet W outside the vacuum chamber 210 maintaining vacuum state.

When the treatment portion A of the metal sheet W passed through the upstream side pulse transformer 260, negative high voltage pulse is generated from the pulse voltage generating unit 250. The negative high voltage pulse is induced to the treatment portion A of the metal sheet W through the pulse transformers 260, 270. The upstream side pulse transformer 260 and the downstream side pulse transformer 270 have the same property and the first winding wires 264, 274 of the pulse transformers 260, 270 are wound in opposite directions. Thus, the voltage induced to the metal sheet W by pulse transformers 260, 270 is offset outside the boundary of the treatment portion A. Therefore the surface treatment portion is confined to the portion located between the upstream pulse transformer 260 and the downstream pulse transformer 270.

Next, a plasma sheath is generated around the treatment portion A by the negative high voltage pulse, and positive ions in the plasma sheath are accelerated toward the treatment portion A, and impact against the surface of the treatment portion A. Contaminants on the surface of the treatment portion are removed by the collision of the ions. The metal sheet W of which surface was treated discharged through the outlet 214 of the vacuum chamber 210 and is wound by the winder 290 as described above. By these processes described above it is possible to accomplish the surface treatment of a conductive metal object continuously.

[The third embodiment]

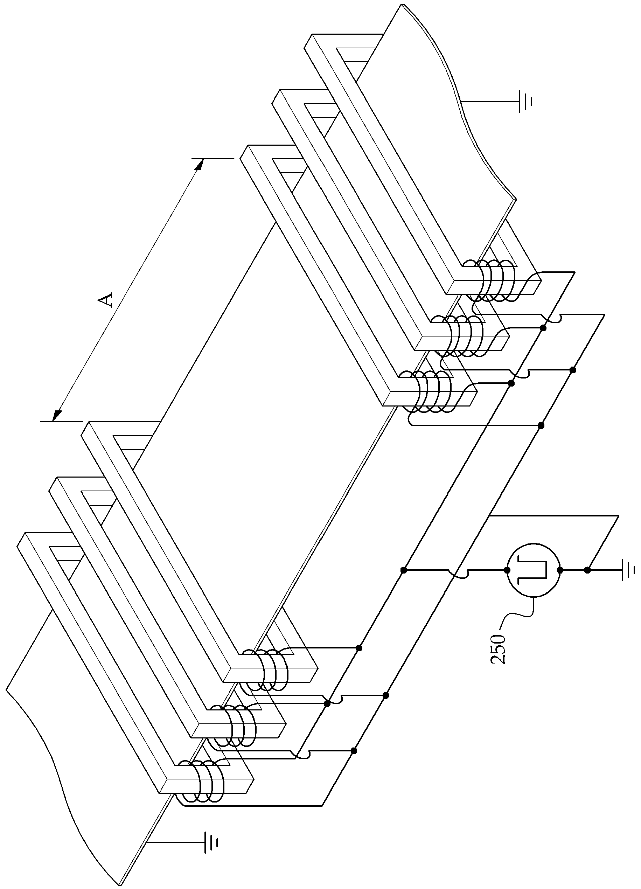

FIG. 8 shows a placement of a pulse transformer installed in a third embodiment of an apparatus for plasma surface treatment according to the present invention. In this embodiment, the apparatus for plasma surface treatment uses multiple sets of pulse transformers serially disposed at the upstream and the downstream of the treatment portion A to increase the voltage induced to the treatment portion A of the wound metal sheet W.

[The fourth embodiment]

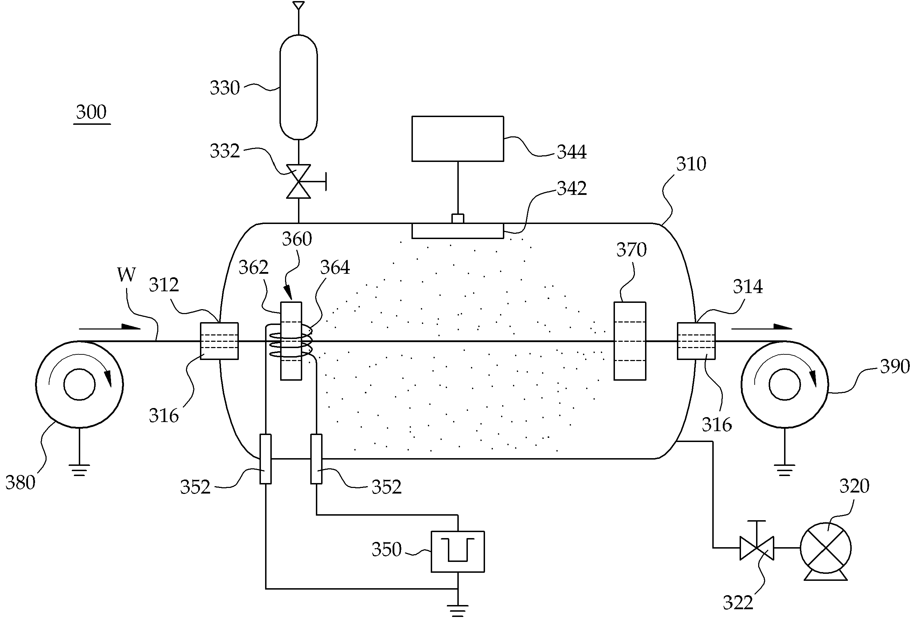

FIG. 9 is a schematic diagram of a forth embodiment of an apparatus for plasma surface treatment according to the present invention. In this embodiment, the apparatus for plasma surface treatment includes a magnetic core 370 instead of the pulse transformer 270 of the second embodiment at the downstream of the treatment portion A.

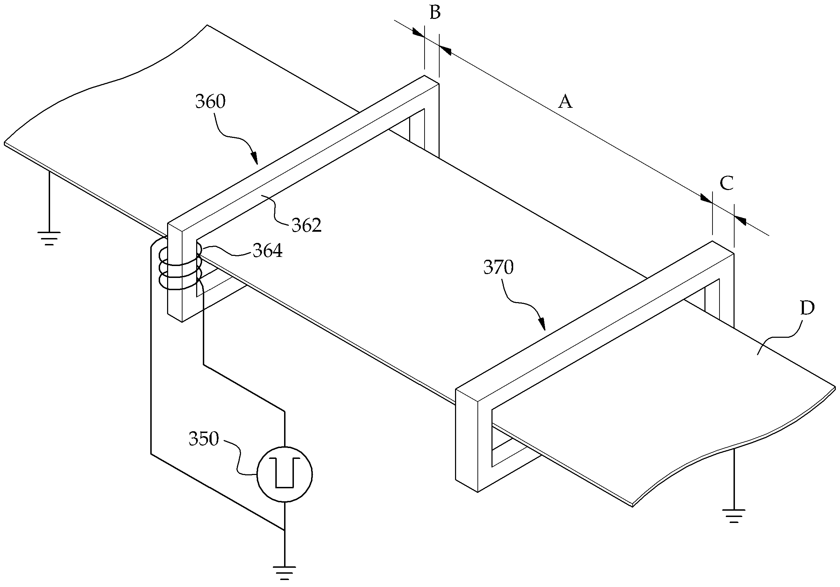

The magnetic core 370 is disposed at the downstream of the treatment portion A. The magnetic core 370 prevents electric current caused by negative voltage pulses induced to the treatment portion A from flowing across the boundary of the treatment portion A. FIG. 10 shows a placement of a pulse transformer and magnetic cores of the apparatus for plasma surface treatment illustrated in FIG. 9. Referring to FIG. 10, magnetic core 370 is closed-loop encompassing the metal sheet W at a predetermined distance. The metal sheet W passes through the opening of closed-loop.

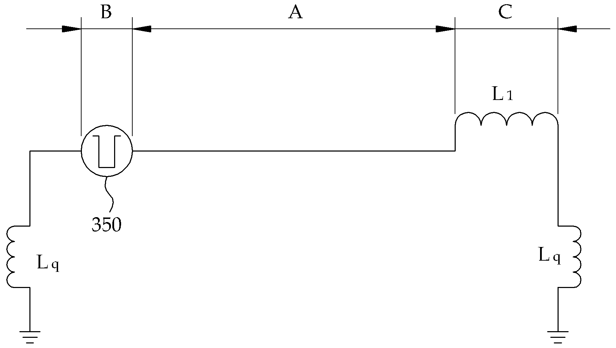

Referring to FIG. 10 and FIG. 11 an electrical equivalent circuit of the portion illustrated in FIG. 10, it will be described that how the magnetic cores 370 prevent the electric current generated by the application of the negative voltage pulses from flowing across the boundary of the treatment portion A of the metal sheet W. The magnetic core 370 is made of high relative permeability materials, so that the magnetic core 370 has high inductance L1. A portion D of the metal sheet W has inductance Lq. The metal sheet W is wound around the winder 380 and the un-winder 390, so the metal sheet W is electrically connected with the winder 380 and the un-winder 390 and the winder 380 and the un-winder 390 are grounded. As a result, the metal sheet W is grounded too.

The purse voltage induced by the pulse transformer disposed at the upstream of the treatment portion A is the sum of the voltage drop by magnetic core 370 and the voltage drop at portion D. The frequency of the negative voltage pulses is so high that a voltage drop due to the resistance of the metal sheet W can be ignored in compare with the voltage drop at the magnetic core 370 and the portion D of the metal sheet W. Thus, an electrical equivalent circuit of the portion of FIG. 10 can be used. The voltage drop at the magnetic core 370 is proportional to the inductance L1 of the magnetic core 370 and the voltage drop at the portion D is proportional to the inductance Lq. So, if the inductance L1 is much higher than the inductance Lq, most of the voltage drop is occurred at the magnetic core 370. To put it differently, to reduce the voltage loss at the region D, it is required that the inductance L1 is much higher than the inductance Lq. The inductance L1 of the magnetic core 370 can be increased by increasing the turns of winding wire and using the high relative permeability materials.

While certain preferred embodiments of the present invention have been described hereinabove, the present invention shall not be limited thereto. It will be apparent to those skilled in the art that various changes and modifications may be made without departing from the scope of the invention defined in the claims.

As one modified embodiment, the surface treatment can be processed in atmospheric pressure.

Also, in the first embodiment, the connecting means other than electric roller can be used. For example, a carbon brush or carbon current collector can be used as the connecting means.

Also, the means to continuously provide the metal sheet other than the un-winder and the winder can be used.

Also, though only the metal sheet is described as an object in embodiments, it will be apparent that a metal wire can be treated and conductive materials other than metal can be treated.

As another modified embodiment, pulse transformer can be installed outside the vacuum chamber.

## Claims

1. An apparatus for plasma surface treatment which treats a surface of a treatment portion of a conductive object using ions from plasma comprising:
connecting means electrically connected to the treatment portion for applying negative voltage pulses to the treatment portion;
a pulse voltage generating unit electrically connected to the connecting means; and
magnetic cores disposed at the boundary of the treatment portion for preventing electric current caused by the negative voltage pulses applied to the treatment portion from flowing across the boundary of the treatment portion.

2. The apparatus of claim 1, further comprising a vacuum chamber enclosing the conductive object.

3. The apparatus of claim 1 or 2, wherein the conductive object is provided continuously, and the connecting means is configured to apply the negative voltage pulses to the treatment portion of the continuously provided conductive object.

4. The apparatus of claim 3, wherein the connecting means comprises an electric roller installed rotatably, wherein the electric roller contacts with the treatment portion.

5. The apparatus of claim 3, wherein the vacuum chamber comprising:
an inlet through which the conductive object is provided;
an outlet through which the conductive object treated is discharged;
sealing means installed at the inlet and the outlet for maintaining vacuum state of the vacuum chamber in the process of providing and discharging the conductive object.

6. The apparatus of claim 1 or 2, wherein the magnetic cores are in the form of closed-loops encompassing the surface of the conductive object at a predetermined distance, wherein the conductive object passes through the openings of the magnetic cores.

7. The apparatus of claim 3, further comprising an un-winder installed at the upstream of the inlet of the vacuum chamber and a winder installed at the downstream of the outlet of the vacuum chamber to continuously provide and discharge the conductive object.

8. A method for plasma surface treatment comprising the steps of:
disposing magnetic cores at a boundary of a treatment portion of a conductive object for preventing electric current from flowing across the boundary of the treatment portion;
supplying a process gas;
generating plasma of ions surrounding the conductive object; and
applying negative voltage pulses to the treatment portion of the conductive object to accelerate the ions from the plasma toward the conductive object to impact the conductive object with the ions.

9. The method of claim 8, further comprising the step of providing under atmospheric pressure condition for the treatment portion of the conductive object.

10. The method of claim 8, further comprising the step of continuously providing the conductive object.

11. An apparatus for plasma surface treatment which treats a surface of a treatment portion of a conductive object using ions from plasma comprising:
at least a pair of pulse transformer cores disposed at the boundary of the treatment portion and configured to induce negative voltage pulses within the treatment portion;
first winding wires wound around each of the pulse transformer cores;
and
a pulse voltage generating unit electrically connected to the first winding wires.

12. An apparatus for plasma surface treatment which treats a surface of a treatment portion of a conductive object using ions from plasma comprising:
a pulse transformer core disposed at the boundary of the treatment portion for inducing negative voltage pulses in the treatment portion;
a first winding wire wound around the pulse transformer core;
a pulse voltage generating unit electrically connected to the first winding wire; and
a magnetic core disposed at the boundary of the treatment portion for preventing electric current caused by the negative voltage pulses in the treatment portion from flowing across the boundary of the treatment portion.

13. The apparatus of claim 11 or 12, further comprising a vacuum chamber enclosing the conductive object.

14. The apparatus of claim 13, wherein the vacuum chamber comprising:
an inlet through which the conductive object is provided;
an outlet through which the conductive object treated is discharged;
sealing means installed at the inlet and the outlet for maintaining vacuum state of the vacuum chamber in the process of providing and
discharging the conductive object.

15. The apparatus of claim 11 or 12, wherein the pulse transformer core is in the form of closed-loop encompassing the surface of the conductive object at a predetermined distance, wherein the conductive object passes through the opening of the pulse transformer core.

16. The apparatus of claim 13, further comprising an un-winder installed at the upstream of the inlet of the vacuum chamber and a winder installed at the downstream of the outlet of the vacuum chamber to continuously provide and discharge the conductive object.

17. A method for plasma surface treatment comprising the steps of:
disposing at least a pair of pulse transformer cores configured to induce negative voltage pulses within a treatment portion of a conductive object at the boundary of the treatment portion;
supplying a process gas;
generating plasma of ions surrounding the conductive object; and
accelerating the ions from the plasma toward the conductive object to impact the conductive object with the ions by applying negative voltage pulses to the pair of pulse transformer cores.

18. A method for plasma surface treatment comprising the steps of:
disposing a pulse transformer core configured to induce negative voltage pulses in a treatment portion of a conductive object at the boundary of the treatment portion;
disposing a magnetic core at the boundary of the treatment portion of the conductive object for preventing electric current from flowing across the boundary of the treatment portion;
supplying a process gas;
generating plasma of ions surrounding the conductive object; and
accelerating the ions from the plasma toward the conductive object to impact the conductive object with the ions by applying negative voltage pulses to the pair of pulse transformer cores.

19. The method of claim 17 or 18, further comprising the step of providing under atmospheric pressure condition for the treatment portion of the conductive object.

20. The method of claim 19, further comprising the step of continuously providing the conductive object.
